# EUROPÄISCHE PATENTSCHRIFT

(11) **EP 2 077 344 B1**
(45) Veröffentlichungstag und Bekanntmachung des Hinweises auf die Patenterteilung: **03.11.2010**
(21) Anmeldenummer: 07024950.3
(22) Anmeldetag: 21.12.2007
(51) Int. Cl.: C30B 25/02, C30B 29/04, C23C 16/02, C23C 16/27, C04B 41/91

(54) **Verfahren zur Aufbringung einer Diamantschicht auf ein Graphitsubstrat**
Method of applying a diamond layer to a graphite substrate
Procédé destiné au dépot d'une couche de diamant sur un substrat de graphite

(43) Veröffentlichungstag der Anmeldung: 08.07.2009
(73) Patentinhaber: CONDIAS GMBH, 25524 Itzehoe (DE)
(72) Erfinder: Fryda, Matthias, 25524 Itzehoe (DE); Matthée, Thorsten, 24482 Hohenaspe (DE); Mulcahy, Shane, 22529 Hamburg (DE)
(74) Vertreter: Lins, Edgar

(56) Entgegenhaltungen:
- WO-A-94/11545
- US-A- 6 099 966
- FRYDA M ET AL: "Fabrication and application of Diachem<(>R) electrodes" DIAMOND AND RELATED MATERIALS, ELSEVIER SCIENCE PUBLISHERS, AMSTERDAM, NL, Bd. 12, Nr. 10-11, 1. Oktober 2003 (2003-10-01), Seiten 1950-1956, XP004479890 ISSN: 0925-9635

## Beschreibung

Die Erfindung betrifft ein Verfahren zur Aufbringung einer Diamantschicht auf ein Graphitsubstrat nach einem CVD-Prozess.

Es ist bekannt, dass Diamantbeschichtungen auf geeigneten Substraten dadurch herstellbar sind, dass in einem CVD (chemical vapor diposition)-Prozess Diamantkristalle aus einer kohlenstoffhaltigen Gasphase in einer Vakuumbeschichtungsanlage abgeschieden werden. Die Prozessgase sind dabei Wasserstoff (H₂) und Methan (CH₄). Die Abscheidung der Diamantphase (sp³-Kohlenstoffmodifikation) setzt voraus, dass die an sich thermodynamisch stabilere kristalline Phase des Kohlenstoffs (sp²-Kohlenstoffmodifikation - Graphit) unterdrückt wird. Hierfür wird eine hohe Konzentration an atomaren Wasserstoff verwendet, da die Wasserstoffatome das Diamantwachstum stabilisieren, indem sie Doppelbindungen aufbrechen und die unerwünschten Kohlenstoffphasen selektiv wegätzen. Die benötigten Wachstumsbedingungen werden dadurch erzeugt, dass das Prozessgas thermisch oder durch Plasma aktiviert wird. Es ist bekannt, als Prozessgas 1 % Methan in Wasserstoff zu verwenden und eine Wachstumstemperatur von 700 bis 1000°C sowie einen Gasdruck zwischen 40 und 400 mbar anzuwenden.

Es besteht ein Bedarf für elektrochemische Anwendungen, bei denen Diamantelektroden mit einer Diamantschicht auf einem Graphit-Elektrodenkörper als Graphitsubstrat aufgebaut sind. Das Problem für die Herstellung einer Diamantbeschichtung auf einem Graphitsubstrat nach dem CVD-Prozess besteht darin, dass bei der CVD-Beschichtung immer auch Graphit gebildet wird, der durch den atomaren Wasserstoff weggeätzt und damit entfernt wird. Bei der Verwendung eines Graphitsubstrats bildet das Substrat eine praktisch unerschöpfliche Quelle an ätzbarem Kohlenstoff, sodass das übliche CVD-Verfahren für die Diamantbeschichtung eines Graphitsubstrats nicht anwendbar ist.

Eine Lösung des Problems ist darin gefunden worden, dass das Graphitsubstrat mit einer inerten Metallschicht als Zwischenlage, beispielsweise aus Gold, versehen worden ist, um eine Entkopplung des Ätzens des Graphitsubstrats von dem beim CVD-Prozess erwünschten Wegätzen von unerwünscht gebildeten sp²-Kohlenstoff-modifikationen zu erreichen. Diese Lösung ist für zahlreiche elektrochemische Anwendungen allerdings nicht brauchbar, da auch Edelmetalle in manchen Elektrolyten nicht stabil sind.

Das der Erfindung zugrunde liegende Problem besteht somit darin, dass für bestimmte elektrochemische Anwendungen eine Diamantelektrode mit einem Graphitsubstrat nicht zur Verfügung steht, da eine unmittelbare Aufbringung einer Diamantbeschichtung auf ein Graphitsubstrat in zuverlässiger Weise nicht gelungen ist.

Der Erfindung liegt daher die Aufgabe zugrunde, eine zuverlässige Diamantbeschichtung auf einem Graphitsubstrat zu ermöglichen.

Zur Lösung dieser Aufgabe wird das Graphitsubstrat vor dem CVD-Prozess folgenden Vorbehandlungsschritten unterworfen:
- Feinreinigung der Oberfläche im Vakuum bei einer Temperatur > 500°C, vorzugsweise > 800°C, in einer Ätzgasatmosphäre,
- mechanisches Entfernen loser Partikel,
- Bekeimung der Substratoberfläche mit kleinsten Diamantpartikeln und
- wenigstens eine Ausgasungsbehandlung im Vakuum zum Entfernen adsorbierter Kohlenwasserstoffe und adsorbierter Luft bei einer Temperatur T > 500°C, vorzugsweise T > 700°C.

Das erfindungsgemäße Verfahren erlaubt erstmalig die unmittelbare Aufbringung einer Diamantschicht auf einem Graphitsubstrat in einem CVD-Prozess. Dem erfindungsgemäßen Verfahren liegt die Erkenntnis zugrunde, dass das Graphitsubstrat, vorzugsweise in Form eines Elektrodenkörpers, in geeigneter Weise vorbehandelt werden muss, wobei die Vorbehandlung sicherstellen soll, dass bei der Beschichtung im CVD-Prozess schnell eine geschlossene Diamantschicht gebildet wird, die als Schutzschicht für das Substrat dient und das Substrat vor dem Ätzen mit dem Wasserstoffgas schützt. Wenn die Schutzschicht gebildet ist, läuft der Beschichtungsprozess wie bei einem üblichen metallischen Elektrodenkörper ab.

Dam erfindungsgemäßen Verfahren kann, falls erforderlich, ein Grobreinigungsschritt vorgeschaltet werden, mit dem etwaigen Fett- und/oder Ölrückständen entfernt werden, sodass das Aufwachsen der Diamantschicht auf dem Graphitsubstrat möglich ist. Ein wesentlicher Schritt des erfindungsgemäßen Verfahrens besteht in der Bekeimung der Oberfläche des Graphitsubstrats. Die an sich bekannte Bekeimung wird erfindungsgemäß dadurch vorbereitet, dass die Substratoberfläche feingereinigt wird, und zwar mit einem Ätzvorgang. Hierzu wird die Oberfläche des Graphitsubstrats im Vakuum in einer Ätzgasatmosphäre, vorzugsweise einer Wasserstoffatmosphäre, einer Temperatur > 500°C, vorzugsweise > 700°C und besonders bevorzugt > 800°C, unterworfen. Bei dieser Behandlung werden aus dem Graphit Graphitpartikel frei gelegt. Randgruppen, beispielsweise in Form von CH₃-, CH₂-, CO-Gruppen, können daher aus dem Graphitverbund zu losen Partikeln gebildet werden, die anschließend mechanisch entfernt werden. Nachdem die Oberfläche des Graphitsubstrats auf diese Weise frei geätzt worden ist, erfolgt die Bekeimung der Substratoberfläche mit kleinsten Diamantpartikeln. Die Bekeimung führt in an sich bekannter Weise dazu, dass sich die wachsende Diamantschicht an bereits vorhandenem Diamantmaterial anlagert und damit schneller und homogener aufwachsen kann als ohne Bekeimung. Die Bekeimung kann mittels einer Suspension mit einer alkoholischen oder wässrigen Flüssigkeit erfolgen. Diese Flüssigkeit zieht in die poröse Oberfläche des Graphits und adsorbiert dort, sodass eine gleichmäßige Verteilung der Diamantpartikel auf der Oberfläche des Graphitsubstrats erfolgt.

Graphitsubstrate bestehen üblicherweise nicht aus Vollmaterial, sondern aus gesintertem und/oder verpresstem Material. Dies hat zur Folge, dass Graphitsubstrate eine erhebliche Porosität aufweisen. Die Porosität variiert entsprechend den Graphittypen je nach Herstellparametern und nach Herstellverfahren. Für das erfindungsgemäße Verfahren ist es wichtig, dass die durch die Vorbehandlungsschritte an der Oberfläche bzw. an den von der Oberfläche zugänglichen Porenoberflächen angelagerte Luft, Kohlenwasserstoffe und Wasser entfernt werden. Das Graphitsubstrat wird erfindungsgemäß daher wenigstens einer Ausgasungsbehandlung unterzogen, um adsorbierte Kohlenwasserstoffe und adsorbierte Luft zu entfernen. Hierfür wird eine Temperatur > 500°C, vorzugsweise > 700°C und besonders bevorzugt > 800°C verwendet. Sofern das Graphitsubstrat, beispielsweise bei der Bekeimung, mit Wasser behandelt worden ist, wird die Ausgasungsbehandlung auch zur Entfernung allen Wassers durchgeführt.

Die erfindungsgemäße Vorbehandlung erlaubt erstmalig die Herstellung belastbarer Diamantbeschichtungen auf Graphitsubstraten, insbesondere für Diamantelektroden mit Graphit als Elektrodenkörper. Dadurch werden neue Anwendungsgebiete für Diamantelektroden erschlossen.

Es ist zu beachten, dass die erfindungsgemäßen Verfahrensschritte für die Vorbehandlung des Graphitsubstrats notwendig sind, allerdings nicht in einer bestimmten vorgegebenen Reihenfolge. So kann das mechanische Entfernen der losen Partikel auch am Ende der Ausgasungsbehandlung bzw. auch zusätzlich am Ende der Ausgasungsbehandlung durchgeführt werden. Denkbar ist ferner, dass die Bekeimung der Substratoberfläche mit den Diamantpartikeln nach der Ausgasungsbehandlung erfolgt. Wenn die Bekeimung in einer bevorzugten Ausführungsform mittels einer Suspension erfolgt, muss anschließend lediglich die Suspensionsflüssigkeit in einem Desorptionsschritt entfernt werden.

Der Schritt der Grobreinigung wird vorzugsweise mit einem organischen Lösungsmittel, beispielsweise Isopropanol, durchgeführt. Es ist sinnvoll, anschließend einen Desorptionsschritt zur Entfernung des Lösungsmittels bei einer erhöhten Temperatur > 150°C, beispielsweise 170°C, durchzuführen. Diese Desorption im Sinne einer Temperung wird für eine in Abhängigkeit von der Dicke und Porosität des Graphitsubstrats ausreichenden Zeit durchgeführt.

Der Feinreinigungsprozess findet vorzugsweise in einer Wasserstoffatmosphäre bei einem Gasdruck < 10 mbar statt. Auch hier hängt die Dauer der Behandlung von der Porosität und Dicke des Graphitsubstrats ab.

Die mechanische Entfernung der losen Partikel von der Graphitoberfläche kann vorzugsweise durch Abwischen oder Abpusten der Oberfläche erfolgen.

Die Ausgasungsbehandlung bei der erfindungsgemäß vorgesehenen erhöhten Temperatur (> 500°C) zum Entfernen adsorbierten Kohlenwasserstoff und adsorbierter Luft findet vorzugsweise unmittelbar vor dem CVD-Prozess statt. Gegebenenfalls kann lediglich die Entfernung loser Partikel erstmalig oder nochmals erfolgen.

Die erfindungsgemäßen Vorbehandlungsschritte können auch in mehreren Stufen durchgeführt werden. So kann es zweckmäßig sein, ein zur Entfettung benutztes Lösungsmittel anschließend sofort in einem geeigneten Desorptionsschritt zu entfernen. Gleiches gilt für die Entfernung des Suspensionsmittels, wenn die Bekeimung der Graphitoberfläche mit einer Diamantsuspension vorgenommen wird. Durch diese Zwischenschritte wird eine Entlastung der hauptsächlichen Ausgasungsbehandlung, durch die adsorbierte Kohlenwasserstoffe und adsorbierte Luft von der Oberfläche und insbesondere aus den oberflächlich zugänglichen Poren entfernt werden, erreicht.

In einem Beispiel ist die erfindungsgemäße Vorbehandlung wie folgt vorgenommen worden:
- Grobreinigung der Graphitoberfläche zur Entfettung / Entölung mittels eines Isopropanols als organisches Lösungsmittel,
- Desorptionsschritt zum Entfernen des Lösungsmittels und des desorbierten Wassers mittels einer Temperung bei 170°C für zwei Stunden bei einem Graphitsubstrat von 10 mm Dicke,
- Ausgasen der Kohlenwasserstoffe und der Luft im Vakuum (Druck
   < 10 mbar) für 10 Stunden,
- Feinreinigung der Oberfläche durch Behandlung im Vakuumverfahren mittels einer Temperung bei 870°C im Wasserstoffgas bei 7mbar Gasdruck für etwa eine Stunde,
- mechanische Entfernung (durch Abwischen) der bei der Feinreinigung auf der Oberfläche entstandenen losen Partikel,
- Bekeimung der Graphitoberfläche mit einer Diamantsuspension mittels eines wässrigen/alkoholischen Suspensionsmittels,
- Desorptionsschritt zum Entfernen des wässrigen Suspensionsmittels mittels einer Temperung bei 170°C für etwa zwei Stunden an Luft (bei der Dicke des Graphitsubstrats von 10 mm),
- Ausgasen der Kohlenwasserstoffe und der Luft vor dem eigentlichen Beschichtungsschritt bei einer Temperatur über 800°C für 10 Stunden im Vakuum.

An diesem Beispiel wird deutlich, dass zwei Ausgasungsbehandlungen erfolgen, um in zwei Schritten eine sichere Entfernung adsorbierter Kohlenwasserstoffe und adsorbierter Luft zu erreichen. Die dabei verwendeten Behandlungszeiten sind nicht optimiert, sondern auf eine mit Sicherheit ausreichend lange Behandlungszeit eingestellt.

In der nachfolgenden Diamantbeschichtung nach dem CVD-Prozess werden die Parameter so eingestellt, dass es zu einem starken Ätzen des Graphits kommt. Durch die Vorbehandlung und die Bekeimung wird eine schnelle geschlossene Diamantschicht gebildet, die das Graphitsubstrat vor dem weiteren Ätzen durch das Wasserstoffgas schützt, sodass der weitere Schichtaufbau in herkömmlicher Weise erfolgt und mit den herkömmlichen Parametern des CVD-Prozesses eingestellt werden kann. Die bevorzugte Gasphasenzusammensetzung ist 1 % CH₄ in H₂, der bevorzugte Gasdruck während der Beschichtung beträgt 5 bis 50 mbar, weiter bevorzugt 10 bis 30 mbar, besonders bevorzugt 10 bis 20 mbar.

## Patentansprüche

1. Verfahren zur Aufbringung einer Diamantschicht auf ein Graphitsubstrat nach einem CVD-Prozess, bei dem das Graphitsubstrat vor dem CVD-Prozess folgenden Vorbehandlungsschritten unterworfen wird:
- Feinreinigung der Oberfläche im Vakuum bei einer Temperatur
> 500°C, vorzugsweise > 800°C, in einer Ätzgasatmosphäre,
- mechanisches Entfernen loser Partikel,
- Bekeimung der Substratoberfläche mit kleinsten Diamantpartikeln und
- wenigstens eine Ausgasungsbehandlung im Vakuum zum Entfernen adsorbierter Kohlenwasserstoffe und adsorbierter Luft bei einer Temperatur T > 500°C, vorzugsweise T > 700°C.

2. Verfahren nach einem der Anspruch 1, bei dem der Feinreinigungsprozess in einer Wasserstoffatmosphäre durchgeführt wird.

3. Verfahren nach Anspruch 2, bei dem die Wasserstoffatmosphäre mit einem Gasdruck < 10 mbar eingestellt wird.

4. Verfahren nach einem der Ansprüche 1 bis 3, bei dem die Bekeimung der Substratoberfläche mit einer Diamantpartikelsuspension durchgeführt wird.

5. Verfahren nach Anspruch 4, bei dem das Suspensionsmittel anschließend durch Erwärmen des Graphitsubstrats entfernt wird.

6. Verfahren nach einem der Ansprüche 1 bis 5, bei dem die Ausgasungsbehandlung unmittelbar vor dem CVD-Prozess erfolgt.

7. Verfahren nach einem der Ansprüche 1 bis 6, bei dem CVD-Prozess mit einer Gaszusammensetzung von 0,5 bis 3,0 %, vorzugsweise 2 % Methan in Wasserstoff durchgeführt wird.

8. Verfahren nach einem der Ansprüche 1 bis 7, bei dem ein Grobreinigungsschritt vorgeschaltet wird.

9. Verfahren nach Anspruch 1, bei dem Grobreinigungsschritt mit einem organischen Lösungsmittel durchgeführt wird.

10. Verfahren nach Anspruch 9, bei dem anschließend ein Desorptionsschritt zur Entfernung des Lösungsmittels bei einer erhöhten Temperatur > 150°C durchgeführt wird.

## Claims

1. Method for applying a diamond layer onto a graphite substrate by a CVD process, wherein the graphite substrate is subjected to the following pretreatment steps before the CVD process:
- fine cleaning of the surface in a vacuum at a temperature > 500°C, preferably > 800°C, in an etching gas atmosphere,
- mechanical removal of loose particles,
- seeding of the substrate surface with very small diamond particles and
- at least one degassing treatment in a vacuum to remove adsorbed hydrocarbons and adsorbed air at a temperature T > 500°C, preferably T > 700°C.

2. Method according to Claim 1, wherein the fine cleaning process is carried out in a hydrogen atmosphere.

3. Method according to Claim 2, wherein the hydrogen atmosphere is set at a gas pressure < 10 mbar.

4. Method according to one of Claims 1 to 3, wherein the seeding of the substrate surface is carried out with a diamond particle suspension.

5. Method according to Claim 4, wherein the suspension medium is subsequently removed by heating the graphite substrate.

6. Method according to one of Claims 1 to 5, wherein the degassing treatment takes place immediately before the CVD process.

7. Method according to one of Claims 1 to 6, wherein the CVD process is carried out with a gas composition of from 0.5 to 3.0%, preferably 2% methane in hydrogen.

8. Method according to one of Claims 1 to 7, which is preceded by a coarse cleaning step.

9. Method according to Claim 1, wherein the coarse cleaning step is carried out with an organic solvent.

10. Method according to Claim 9, wherein a desorption step is subsequently carried out to remove the solvent at an elevated temperature > 150°C.

## Revendications

1. Procédé destiné au dépôt d'une couche de diamant sur un substrat de graphite selon un processus de type CVD, dans lequel les étapes préparatoires suivantes sont effectuées sur le substrat de graphite avant le processus de CVD :
- purification de la surface sous vide à une température >500°C, et de préférence >800°C, sous atmosphère de gaz réactif ;
- élimination mécanique des particules libres,
- ensemencement de la surface du substrat avec de très fines particules de diamant, et
- au moins un traitement de dégazage sous vide pour éliminer les particules d'hydrocarbures adsorbées et l'air adsorbé, à une température de T>500°C, et de préférence T>700°C.

2. Procédé selon la revendication 1, dans lequel le processus de purification est mis en oeuvre sous atmosphère d'hydrogène.

3. Procédé selon la revendication 2, dans lequel l'atmosphère d'hydrogène est limitée à une pression <10mbar.

4. Procédé selon l'une quelconque des revendications 1 à 3, dans lequel l'ensemencement de la surface du substrat est réalisée avec une suspension de particules de diamant.

5. Procédé selon la revendication 4, dans lequel le milieu de suspension est ensuite éliminé par chauffage du substrat de graphite.

6. Procédé selon l'une quelconque des revendications 1 à 5, dans lequel le traitement de dégazage est réalisé directement avant le processus de CVD.

7. Procédé selon l'une quelconque des revendications 1 à 6, dans lequel le processus de CVD est mis en oeuvre avec une composition de gaz de 0,5 à 3,0%, et de préférence 2% de méthane dans l'hydrogène.

8. Procédé selon l'une quelconque des revendications 1 à 7, dans lequel il est réalisé au préalable une étape de nettoyage préliminaire.

9. Procédé selon la revendication 1, dans lequel l'étape de nettoyage préliminaire est réalisée avec un diluant organique.

10. Procédé selon la revendication 9, dans lequel une étape de désorption est ensuite réalisée pour éliminer le diluant, par une augmentation de température >150°C.
